# EUROPEAN PATENT APPLICATION

(11) **EP 3 128 605 A1**
(43) Date of publication of application: **08.02.2017**
(21) Application number: 16189642.8
(22) Date of filing: 18.03.2009
(51) Int. Cl.: H01P 3/08, H01P 5/12, H05K 1/18, H05K 3/36, H01Q 15/14

(54) **TRANSMISSION LINE AND A METHOD FOR PRODUCTION OF A TRANSMISSION LINE**

(30) Priority: 19.03.2008 SE 0800642
(62) Divisional of application: 09445008.7
(71) Applicant: Intel Corporation, Santa Clara, CA 95054 (US)
(72) Inventor: Lindmark, Björn, 191 48 Sollentuna (SE)
(74) Representative: Goddar, Heinz J.

(57) **Abstract**

The invention relates to a system (10) comprising a plurality of transmission lines (1), wherein each transmission line (1) comprises an open groove (2) defined by two parallel conducting walls (3) and a conducting floor (4), a centre conductor (5), at least partly submersed in the groove (2), and a printed circuit board (6), wherein the centre conductor (5) comprises at least one conductor formed on one side of the printed circuit board (6). At least two centre conductors (5) of the plurality of transmission lines are connected to each other with a conducting element (9), and the conducting element is running through one of the walls or the floor of the groove of at least one of the transmission lines.

## Description

### Field of the invention

The present invention concerns a transmission line according to the preamble of claim 1. Further, it concerns a method for production of a transmission line.

### Background art

The use of microstrip lines with air as the dielectric has been used in base station antennas since at least the mid-90s. The advantage is low loss and ease of manufacture in the sense that a flat ground plane can be used for the lines. The disadvantage of such lines is the necessary width, which for example at a 3 mm separation is 13 mm for a 50 ohms line. The absence of a dielectric, other than air, also means that the mutual coupling is rather high.

As another prior art in respect of the present invention US patent 5 652 557 could be mentioned. This patent discloses a transmission line consisting of a longitudinal groove in a dielectric material having longitudinal walls and bottom disposed with a metallisation film. In the groove, a conductor line is formed by a metal film.

However, the conductor of US 5 652 557 is manufactured by disposing a conductor film on a dielectric. Such a production method can be complex and expensive, yielding an expensive transmission line.

### Summary of the invention

It is an object of the present invention to propose a solution for or a reduction of the problems of prior art. A main object is consequently to propose a transmission line having beneficial electric properties and at the same time is both rational in construction and easy to employ.

According to the invention this is accomplished by a transmission line having the features of claim 1. Using a centre conductor comprising at least one conductor formed on a side of a printed circuit board (PCB) provides for a simple and relatively cheap construction. Another proposition could be to use a piece of metal as the centre conductor. However, compared to such a piece of metal, a PCB offers prospects of better dimensional accuracy, lower weight, and possibly also lower cost than sheet metal.

According to another aspect of the invention, one or more of the above objectives is achieved with a method for production of a transmission line having the features of claim 13. This is a straightforward method of production that is simple to employ.

Further advantageous embodiments are disclosed in the dependent claims.

### Brief description of the drawings

Embodiments exemplifying the invention will now be described, by means of the appended drawings, in which
Figs. 1a and 1b illustrate schematically a transmission line of the invention,
Figs. 2a and 2b illustrate schematically a case of attenuation properties for the transmission lines of figs. 1a and 1b,
Fig. 3 illustrates transmission lines according to the invention mounted on the back of an antenna reflector,
Figs. 4a-4c illustrate two transmission lines according to the invention, connected to each other with a conducting element,
from different perspectives,
Fig. 5 illustrate a dielectric in an embodiment of the invention,
Fig. 6 illustrates the use of a cross connection between two separate transmission lines, and
Figs. 7a-7b illustrate the use of a plurality of transmission lines of the invention.

### Detailed description of the invention

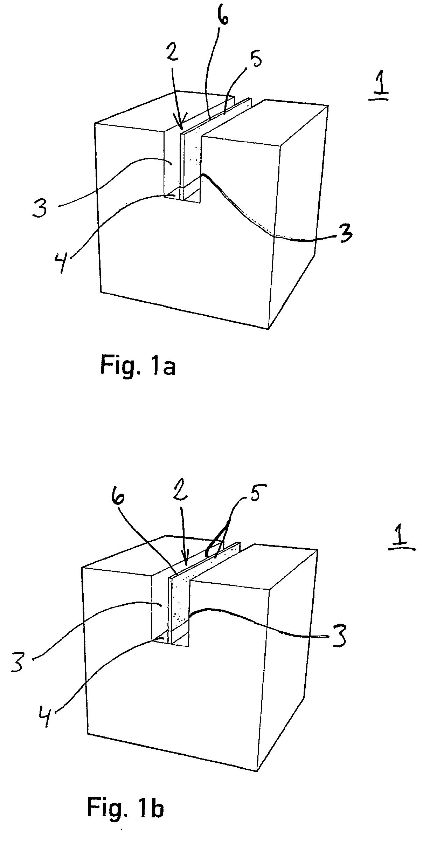

A conceptual embodiment of the invention is shown in fig. 1a. It is a transmission line 1 that comprises:
- a groove 2 defined by two parallel conducting walls 3 and a conducting floor 4 all electrically connected to each other, together forming a peripheral conductor of the transmission line, and
- a centre conductor 5, at least partly submersed in the groove 2, the centre conductor 5 being isolated from the conducting walls 3 and the conducting floor 4 of the groove 2. The centre conductor 5 comprises at least one conductor formed on a side of a printed circuit board 6. The transmission line 1 is working in near transverse electromagnetic mode (TEM-mode) or quasi TEM-mode. The small discrepancy from a full TEM-mode is due to the different permittivity of air and the dielectric material in the thin PCB dielectric surrounding the centre conductor.

Typically, such a conductor formed on a side of a printed circuit board would be a conducting strip formed on the printed circuit board. However, other conductors are in theory not ruled out; it is conceivable to have other types of conductors than strips formed on the printed circuit board.

The design of the transmission line as in fig.1a ensures efficient use of the conducting strip area, since the field is distributed on both sides of the strip due to the surrounding walls and floor of the groove. This means a lower loss compared to a microstrip transmission line. At the same time the open configuration brought about by the groove provides for good accessibility of the line during assembly while still affording mechanical protection of the centre conductor. The production of such a transmission line could be configured to be easy and relatively cheap.

An alternative to the PCB would be to use a piece of sheet metal. However, compared to such a solution, the PCB may provide better dimensional accuracy, lower weight, and possibly also lower cost than such a piece of sheet metal.

In fig. 1b a transmission line is shown wherein the centre conductor 5 comprises two conductors on two sides of the printed circuit board 6, i.e. both sides of the PCB are used for the centre conductor. This solution provides for a slightly lower impedance over a frequency range from 0.50 -2.0 GHz according to simulations, see below.

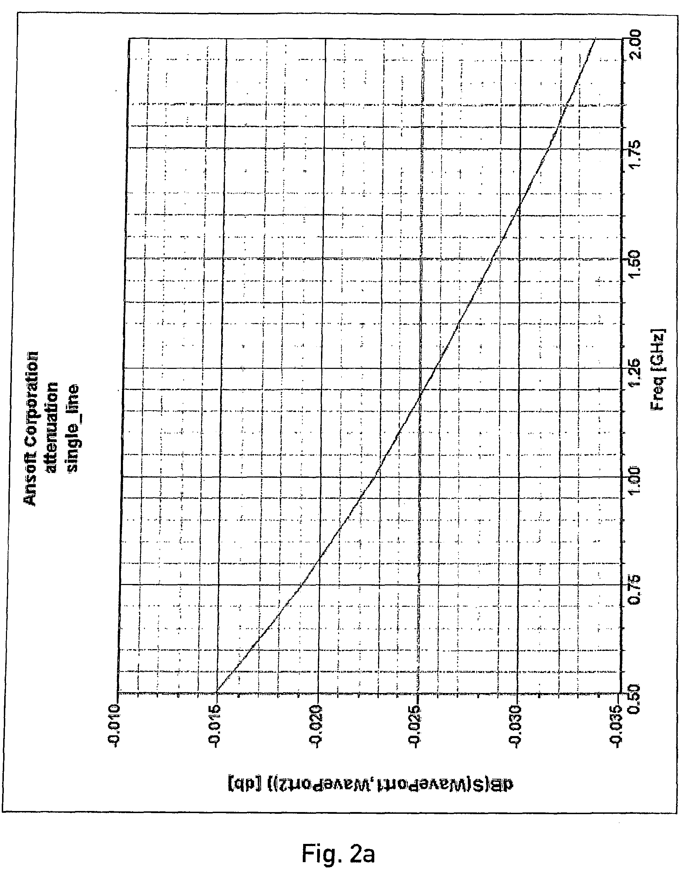

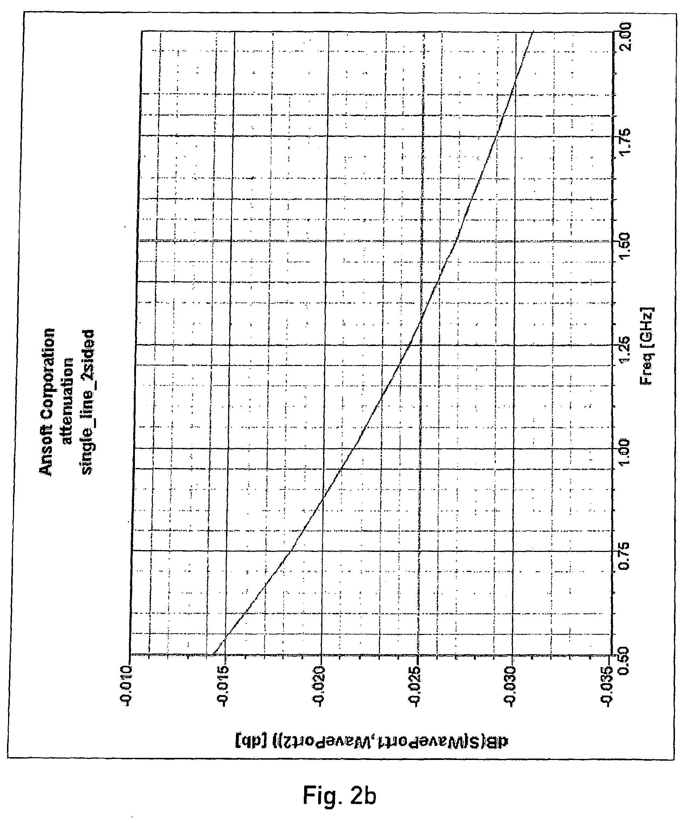

Simulations of the attenuation of the transmission lines in figs. 1a and 1b respectively are shown in figs. 2a and 2b. Fig. 2a corresponds to fig. 1a and fig. 2b corresponds to fig. 1b. Figs. 1a/2a are for a one-sided, 200 mm copper line on a 20 mil (0.508 mm) thick Rogers 4003 substrate. Figs. 1b/2b are for a two-sided, 200 mm copper line on a 20 mil (0.508 mm) thick Rogers 4003 substrate. For both cases, total width of the groove 2 was 8 mm (corresponding to the floor 4), depth was 15 mm (corresponding to the walls 3). Material of walls and floor was aluminium. Line width was 11 mm, line thickness was 35 µm. As can be seen, attenuation is a bit less for the two-sided case of figs. 1b/2b.

Returning to figs. 1a and 1b for awhile, the centre conductor 5 of the transmission line 1, could be formed on the printed circuit board 6 by etching. This means that a high dimensional precision of the centre conductor could be accomplished. Such precision could be attained using standard, and therefore cheap, etching equipment well known in the electronics industry.

In principle, the printed circuit board 6 of the transmission line 1 could be positioned in the groove 2 with its main surfaces perpendicular to the walls 3 of the groove 2. However, when the printed circuit board 6 of the transmission line 1 is positioned in the groove 2 with its main surfaces in parallel with the walls 3 of the groove 2, a more efficient use of the conducting strip area is achieved, resulting in a lower attenuation of the transmission line.

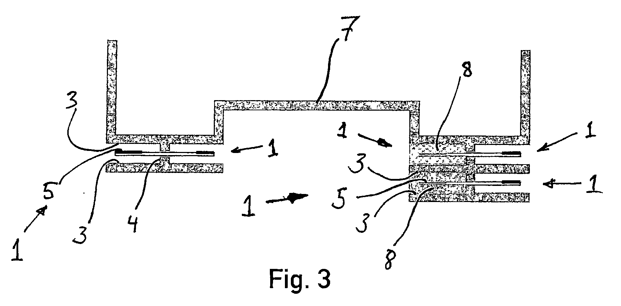

The walls 3 and the floor 4 of the transmission line 1 according to the invention could be constructed in many different ways. They could be separate parts that are joined together by suitable means or an integral part. Such separate parts or integral part could for instance be an aluminium profile, such as an aluminium extrusion. Also, as seen in fig. 3, at least a part of any of the walls 3 and the floor 4 defining the groove could also be a part of an antenna reflector 7. This enables a rational construction wherein e.g. the back of an antenna reflector can be reused as a part of the groove, thus providing a dual function. Fig. 3 illustrates in a side elevation view an antenna reflector having mounted at the back of it a plurality of transmission lines 1. Also shown in Fig. 3 is a slidable dielectric 8 positioned in a space between the centre conductor 5 and at least one of the parallel conducting walls 3. Due to the slidable dielectric, the impedance of a part of the transmission line could be controlled, for instance in order to vary/tune the phase of a signal on the transmission line. The dielectric could be slidable in a suitable direction. In fig. 3 that could be in the direction in or out of the paper. Alternatively it could be in a direction in or out of the groove, i.e. left or right in the figure.

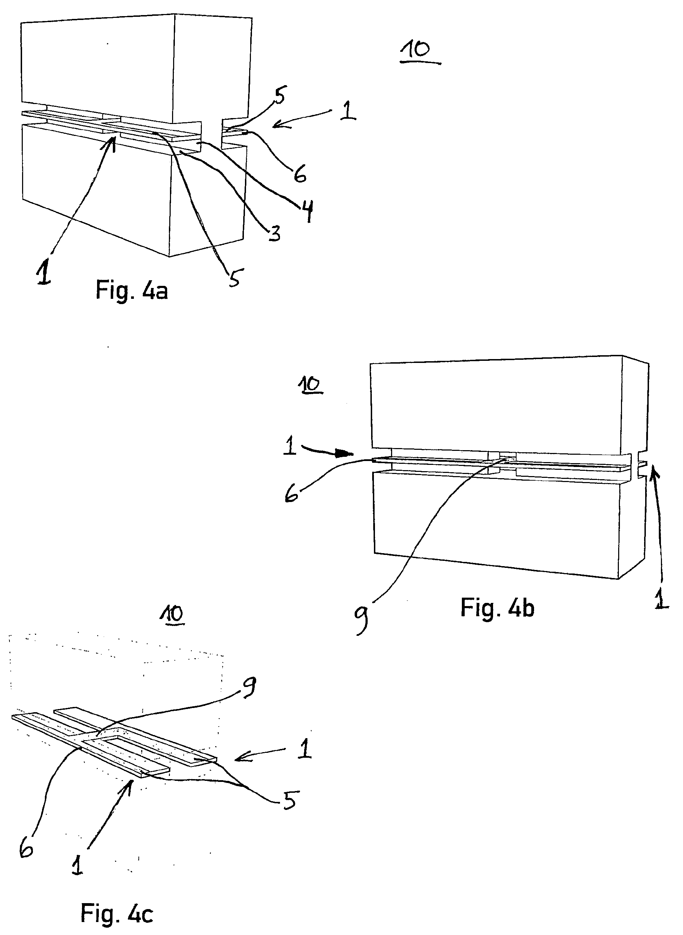

As figs. 4a-c show, a System 10 comprising a plurality of transmission lines 1 according to any of the previously described transmission lines of the invention could be formed, wherein at least two centre conductors 5 of the plurality of transmission lines are connected to each other with a conducting element 9 in order to provide for a dividing of a signal that can enter the system 10 on one of the plurality of transmission lines into at least one other transmission line. The conducting element 9 is shown in fig. 4a-c going through a port between the two grooves of the figure.

Figs. 4a-c all show the same system 10 from different angles and in the case of fig. 4c, also in some translucency in order to clarify the design and placement of a PCB 6 with its centre conductor 5 in the system.

In order to provide for a rational and economical production of such a system 10, at least two centre conductors could be formed on a same printed circuit board 6. That would yield at least two conductors using only one PCB, as can be seen in figs. 4a-c. The forming of at least two centre conductors on the same PCB also has the further benefit that the conducting element 9 between them could be a conductor formed on the printed circuit board 6. In that way, there would not be any requirements for the soldering of wires between the transmission lines.

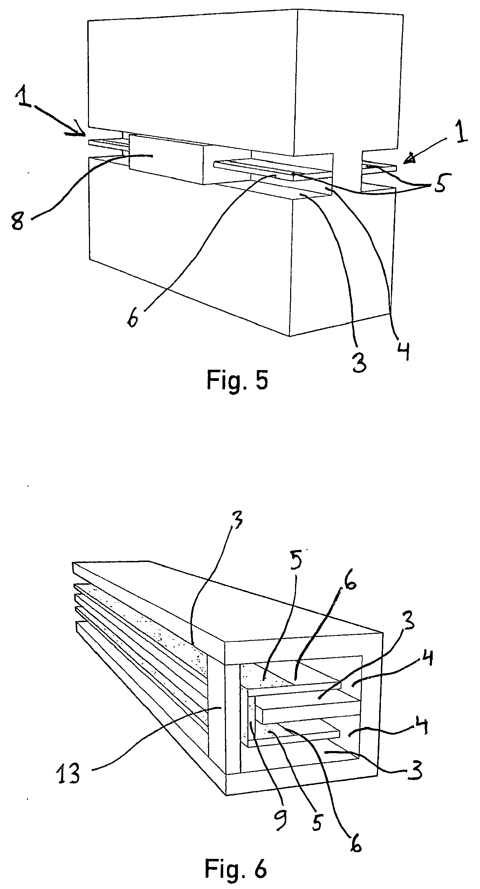

A figure similar to that of figures 4a-c is shown in figure 5 with the addition of a slidable dielectric 8. This is basically a three dimensional schematic view of the slidable dielectric of fig. 3, showing only two transmission lines 1 though.

For the case wherein at least two centre conductors in the system of the invention are on separate printed circuit boards 6, it would be beneficial if the conducting element 9 is running through one of the walls and the floor, that is either through one of the walls or through the floor, of the groove of at least one of the transmission lines, preferably both of the lines. This is shown in figure 6, where a cut out in the middle wall is effected in order to provide space for the conducting element 9. It should be noted that the walls and floors of the at least two transmission lines should share the same voltage potential, in order to avoid any differential modes. In particular, it is important to maintain the same potential of the walls in both transmission lines. It can be seen in fig. 6 that the two centre conductors 5 are connected with a conducting element 9. Further, in order to maintain the same potential of the walls in both transmission lines, a conductor 13 is provided connecting both (outer) walls 3.

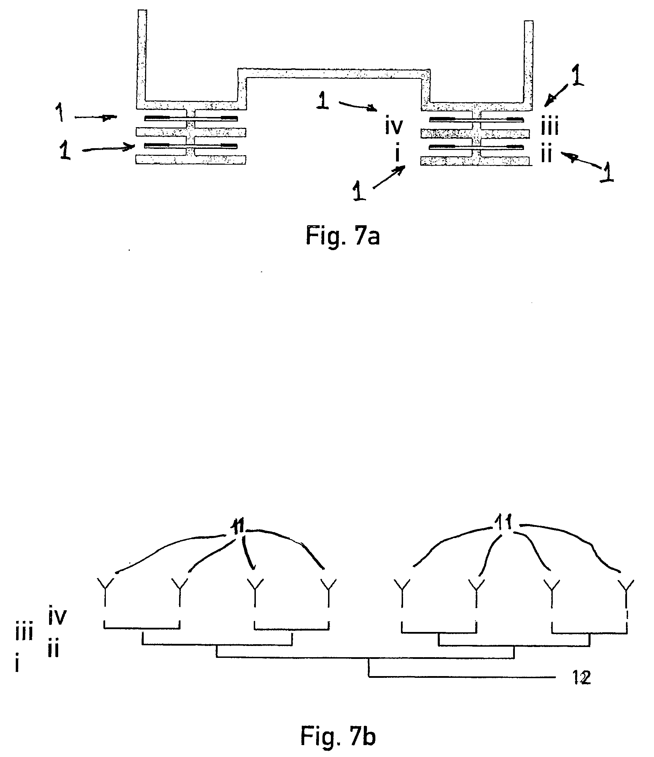

A system 10 as has been described above can, as an example, be put to use as an antenna feed, feeding antenna elements with signals. Thus, such a system could replace the usual coaxial cables in such an application. This could simply be accomplished by having a system of at least two transmission lines according to the invention connected to a corresponding at least two antenna elements 11. (Of course, the use of a singular transmission line of the invention to feed an antenna element is also possible, however that can be though of as just a singular transmission line rather than a system of transmission lines.) In comparison to a system using coaxial cables, this solution has the prospect of being both cheaper and allowing for a more rational production. Such a system in accordance with the invention is depicted in figs. 7a and 7b. Fig. 7a shows a system of transmission lines 1 connected to the back of an antenna reflector (no antenna radiating element is shown in fig. 7a). The different transmission lines 1 in fig. 7a are connected to each other in a way shown schematically in fig. 7b. An antenna feed signal can be supplied at the tail 12 in fig. 7b. This signal is then distributed to the different antenna element pairs 11 by the successive forking of a transmission line into new transmission lines. This can be studied in fig. 7b; each new fork level (or T-branch level) results in a doubling of the number of branches of the transmission lines. Each level is depicted with a roman numeral in fig. 7b and each such corresponding level is indicated in the schematic fig. 7a. In the end, the transmission lines are connected to an antenna element pair 11, as seen in fig. 7b.

The invention also comprises a method for production of a transmission line comprising the steps:
a) manufacturing a groove 2 defined by two parallel conducting walls 3 and a conducting floor 4 all electrically connected to each other, together forming a peripheral conductor of the transmission line, and
b) submersing a centre conductor 5, at least partly in the groove 2, such that the centre conductor 5 is isolated from the conducting walls 3 and the conducting floor 4 of the groove 2, distinguished in that in step b: submersing a centre conductor 5 that comprises at least one conductor on a side of a printed circuit board 6.

The manufacture of a groove 2 in step a) could be accomplished in many ways. For instance by milling in a solid body such as a metal body. Another alternative would be to create a metal profile by extrusion or folding of a metal sheet. A third alternative would be to connect different separate parts that together form the groove. It should be emphasised that any embodiment of the transmission line and the system described above, could be produced in a corresponding step in the method of the invention.

Further examples are as follows:
Example 1: Transmission line (1) comprising:
   - a groove (2) defined by two parallel conducting walls (3) and a conducting floor (4) all electrically connected to each other, together forming a peripheral conductor of the transmission line, and
   - a centre conductor (5), at least partly submersed in the groove (2), the centre conductor (5) being isolated from the conducting walls (3) and the conducting floor (4) of the groove (2), characterised in that
      the centre conductor (5) comprises at least one conductor formed on a side of a printed circuit board (6).
Example 2: Transmission line (1) according to example 1, wherein the centre conductor (5) comprises two conductors on two sides of the printed circuit board (6).
Example 3: Transmission line (1) according to example 1 or 2, wherein the centre conductor (5) is formed on the printed circuit board (6) by etching.
Example 4: Transmission line (1) according to any of examples 1-3, wherein the printed circuit board (6) is positioned in the groove (2) with its main surfaces in parallel with the walls (3) of the groove (2).
Example 5: Transmission line (1) according to any of examples 1-4, wherein the groove (2) is defined by an aluminium profile.
Example 6: Transmission line (1) according to any of examples 1-5, wherein at least a part of any of the walls (3) and the floor (4) defining the groove is a part of an antenna reflector (7).
Example 7: Transmission line (1) according to any of examples 1-6, wherein a slidable dielectric (8) is positioned in a space between the centre conductor (5) and at least one of the parallel conducting walls (3).
Example 8: System (10) comprising a plurality of transmission lines (1) according to any of examples 1-7, wherein at least two centre conductors (5) of the plurality of transmission lines are connected to each other with a conducting element (9) in order to provide for a dividing of a signal that can enter the system (10) on one of the plurality of transmission lines into at least one other transmission line.
Example 9: System (10) according to example 8, wherein at least two centre conductors are formed on a same printed circuit board (6).
Example 10: System (10) according to example 9, wherein the conducting element (9) is a conductor formed on the printed circuit board (6).
Example 11: System (10) according to example 8, wherein at least two centre conductors are on separate printed circuit boards (6) and that the conducting element is running through one of the walls and the floor of the groove of at least one of the transmission lines.
Example 12: System (10) according to any of examples 8-11, wherein at least two transmission lines are connected to a corresponding at least two antenna elements (11).
Example 13: Method for production of a transmission line comprising the steps:
   a) manufacturing a groove (2) defined by two parallel conducting walls (3) and a conducting floor (4) all electrically connected to each other, together forming a peripheral conductor of the transmission line, and
   b) submersing a centre conductor (5), at least partly in the groove (2), such that the centre conductor (5) is isolated from the conducting walls (3) and the conducting floor (4) of the groove (2), characterised in that in step b): submersing a centre conductor (5) that comprises at least one conductor on a side of a printed circuit board (6).

### Legend

- 1: Transmission line
- 2: Groove
- 3: Wall
- 4: Floor
- 5: Centre conductor
- 6: PCB
- 7: Reflector
- 8: Slidable dielectric
- 9: Conducting element
- 10: System
- 11: Antenna element pair
- 12: Tail

## Claims

1. System (10) comprising a plurality of transmission lines (1),
wherein each transmission line (1) comprises:
- an open groove (2) defined by two parallel conducting walls (3) and a conducting floor (4) all electrically connected to each other, together forming a peripheral conductor of the transmission line,
- a centre conductor (5), at least partly submersed in the groove (2), the centre conductor (5) being isolated from the conducting walls (3) and the conducting floor (4) of the groove (2), and
- a printed circuit board (6),
wherein the centre conductor (5) comprises at least one conductor formed on one side of the printed circuit board (6),
and wherein
at least two centre conductors (5) of the plurality of transmission lines are connected to each other with a conducting element (9) in order to provide for a dividing of a signal that can enter the system (10) on one of the plurality of transmission lines into at least one other transmission line, and
at least two centre conductors are on separate printed circuit boards (6) and that the conducting element is running either through one of the walls or through the floor of the groove of at least one of the transmission lines.

2. System (10) according to claim 1, wherein for each transmission line (1) the centre conductor (5) comprises two conductors on two sides of the printed circuit board (6).

3. System (10) according to claim 1 or 2, wherein for each transmission line (1) the centre conductor (5) is formed on the printed circuit board (6) by etching.

4. System (10) according to any of claims 1-3, wherein for each transmission line (1) the printed circuit board (6) is positioned in the groove (2) with its main surfaces in parallel with the walls (3) of the groove (2).

5. System (10) according to any of claims 1-4, wherein for each transmission line (1) the groove (2) is defined by an aluminium profile.

6. System (10) according to any of claims 1-5, wherein for each transmission line (1) at least a part of any of the walls (3) and the floor (4) defining the groove is a part of an antenna reflector (7).

7. System (10) according to any of claims 1-6, wherein for each transmission line (1) a slidable dielectric (8) is positioned in a space between the centre conductor (5) and at least one of the parallel conducting walls (3).

8. System (10) according to claim 1, wherein at least two transmission lines are connected to a corresponding at least two antenna elements (11).
